# EUROPEAN PATENT APPLICATION

(11) **EP 2 175 488 A1**
(43) Date of publication of application: **14.04.2010**
(21) Application number: 08790927.1
(22) Date of filing: 07.07.2008
(51) Int. Cl.: H01L 27/04, H01L 21/336, H01L 29/417, H01L 29/47, H01L 29/78, H01L 29/872

(54) **SEMICONDUCTOR DEVICE AND METHOD FOR MANUFACTURING THE SAME**

(30) Priority: 31.07.2007 JP 2007199122
(71) Applicant: Rohm Co., Ltd., Kyoto-shi, Kyoto 6158585 (JP)
(72) Inventor: HIGASHIDA, Shouji, Kyoto-shi Kyoto 615-8585 (JP)
(74) Representative: TBK-Patent
(86) International application number: PCT/JP2008/062266
(87) International publication number: WO 2009/016928

(57) **Abstract**

A semiconductor device and a fabrication method for the semiconductor device are provided in which an increase of a forward loss is suppressed and a reverse recovery loss is reduced.

A semiconductor device includes a semiconductor substrate (10) having a first conductivity type and forming a drain layer; a base layer (6) disposed on a surface of the semiconductor substrate and having a second conductivity type; a source layer (4) disposed on the base layer (6) and having the first conductivity type; a gate insulating film (2) disposed on the base layer (6) and the source layer (4); a gate electrode (3) disposed on the gate insulating film (2); a source electrode (1) connected to the base layer (6) and the source layer (4); a metal layer (11) disposed on a back side of the semiconductor substrate (10), and subjected to an alloy process with the semiconductor substrate (10); a metal layer (12) disposed on the metal layer (11); a metal layer (14) disposed on the metal layer (12); and a metal layer (16) disposed on the metal layer (14). The fabrication method for such semiconductor device is also provided.

## Description

### TECHNICAL FIELD

The present invention relates to a semiconductor device and a fabrication method for the semiconductor device. In particular, the present invention relates to a semiconductor device for reducing a reverse recovery loss, and a fabrication method for the same.

### BACKGROUND ART

As a semiconductor device, n channel vertical MOSFET (Metal Oxide Semiconductor Field Effect Transistor) is applied to an inverter power supply circuit for driving back lights of an LCD (Liquid Crystal Display), an inverter power circuit of various kinds of air-conditioners, and an inverter power circuit for driving various kinds of lighting devices, etc.

In these various kinds of inverter circuits, a parasitic diode loss in the MOSFET becomes a problem in a practical using circuit. For example, in an inverter circuit, when the circuit configuration to which an n channel vertical MOSFET is applied is implemented, there is a problem that the loss of the circuit becomes large since a reverse recovery time in the parasitic diode (Di) of the n channel vertical MOSFET becomes long.

Accordingly, a current path is avoided and a regenerative current is generated in the circuit in order to suppress an occurrence of a current loss, in which the current flows through the parasitic diode Di. That is, in the circuit, for example, it is performed of ingenuity in a circuit configuration in order to suppress the current flowing through the parasitic diode Di in the n channel vertical MOSFET by connecting an FRD (Fast Recovery Diode) with the n channel vertical MOSFET in inverse parallel.

Accordingly, problems, such as an increase in a mounting area, an increase in using parts, and an increase in cost, have occurred. Moreover, if it is a circuit including Schottky Barrier Diode, FRD for cutoff, etc. such as a back light inverter circuit of an LCD, and an inverter circuit for driving a CCFL (Cold Cathode Fluorescent Lamp), a conduction power loss in the FRD for cutoff will usually occur at the time of the forward current conduction in a current path.

On the other hand, it is already disclosed about a semiconductor device having a rear electrode which made ohmic contact characteristics improve, and a fabrication method for the semiconductor device (for example, refer to Patent Literature 1). In the semiconductor device related to Patent Literature 1, it is characterized by laminating: the Au layer formed on the back side of a silicon substrate including an impurity; the alloy layer including an impurity of the same type as the impurity, and silicon; a layer including only a Au, or an impurity of the same type as the impurity and a Au; and a nickel layer one after another. In the semiconductor device according to the Patent Literature 1, a contact resistance of the rear electrode on the semiconductor device can be reduced.
Patent Literature 1: Japanese Patent Application Laying-Open Publication No. H06-37301

### DISCLOSURE OF INVENTION

### Technical Problem

However, for example, since the ingenuity in the circuit configuration in order to suppress the current flowing through the parasitic diode Di in the n channel vertical MOSFET by connecting the FRD with the n channel vertical MOSFET in inverse parallel is also implemented in the circuit of the semiconductor device according to Patent Literature 1, problems, such as an increase in a mounting area, an increase in number of using parts, and an increase in cost, have occurred.

The purpose of the present invention is to provide a semiconductor device for suppressing an increase in forward loss and reducing reverse recovery loss, and a fabrication method for the semiconductor device.

The purpose of the present invention is to provide a semiconductor device for reducing a mounting area by miniaturizing an FRD for cutoff, suppressing the increase in forward loss substantially, and reducing the reverse recovery loss, by determining the value of a forward voltage V_{f} of the parasitic diode Di in the MOSFET larger than the value of forward voltage V_{F} of the FRD connected to the semiconductor device in parallel, and a fabrication method for the semiconductor device.

### Solution to Problem

According to one aspect of the present invention for achieving the above-mentioned purpose, it is provided with a semiconductor device comprising a semiconductor substrate having a first conductivity type and forming a drain layer; a base layer disposed on a surface of the semiconductor substrate and having a second conductivity type; a source layer disposed on the base layer and having the first conductivity type; a gate insulating film disposed on the semiconductor substrate, the base layer, and the source layer; a gate electrode disposed on the gate insulating film; a source electrode connected to the base layer and the source layer; a first metal layer disposed on a back side of the semiconductor substrate, and subjected to an alloy process with the semiconductor substrate; a second metal layer disposed on the first metal layer; a third metal layer disposed on the second metal layer; and a fourth metal layer disposed on the third metal layer.

According to another aspect of the present invention, it is provided with a semiconductor device comprising an insulated gate field effect transistor comprising a semiconductor substrate having a first conductivity type and forming a drain layer, a base layer disposed on a surface of the semiconductor substrate and having a second conductivity type, a source layer disposed on the base layer and having the first conductivity type, a gate insulating film disposed on the semiconductor substrate, the base layer, and the source layer, a gate electrode disposed on the gate insulating film, and a source electrode connected to the base layer and the source layer; and a metal laminate structure comprising a second metal layer disposed on a first metal layer disposed on a back side of the semiconductor substrate and subjected to an alloy process with the semiconductor substrate, a third metal layer disposed on the second metal layer, and a fourth metal layer disposed on the third metal layer, wherein the semiconductor device includes a Schottky diode applying the metal laminate structure as an anode, and applying the semiconductor substrate as a cathode.

According to another aspect of the present invention, it is provided with a fabrication method for a semiconductor device comprising preparing a semiconductor substrate having a first conductivity type and acting as a drain layer; forming a base layer having a second conductivity type on a surface of the semiconductor substrate; forming a source layer having the first conductivity type on the base layer; forming a gate insulating film on the base layer and the source layer; forming a gate electrode on the gate insulating film; forming a source electrode connected to the base layer and the source layer; forming a first metal layer subject to an alloy processed with the semiconductor substrate on a back side of the semiconductor substrate; forming a second metal layer on the first metal layer; forming a third metal layer on the second metal layer; and forming a fourth metal layer on the third metal layer.

According to another aspect of the present invention, it is provided with an electric appliance comprising an inductance for load, the inductance is driven by the semiconductor device according to any one of claims 1 to 13.

### Advantageous Effects of Invention

According to the semiconductor device and the fabrication method for the semiconductor device of the present invention, the increase in the forward loss can be suppressed and the reverse recovery loss can be reduced.

According to the semiconductor device and the fabrication method for the semiconductor device of a present invention, the mounting area can be reduced by miniaturizing the FRD for cutoff, the increase in forward loss can be suppressed substantially, and the reverse recovery loss can be reduced, by determining the value of the forward voltage V_{f} of the parasitic diode Di of the MOSFET larger than the value of the forward voltage V_{F} of the FRD connected to the semiconductor device in parallel.

### BRIEF DESCRIPTION OF THE DRAWINGS

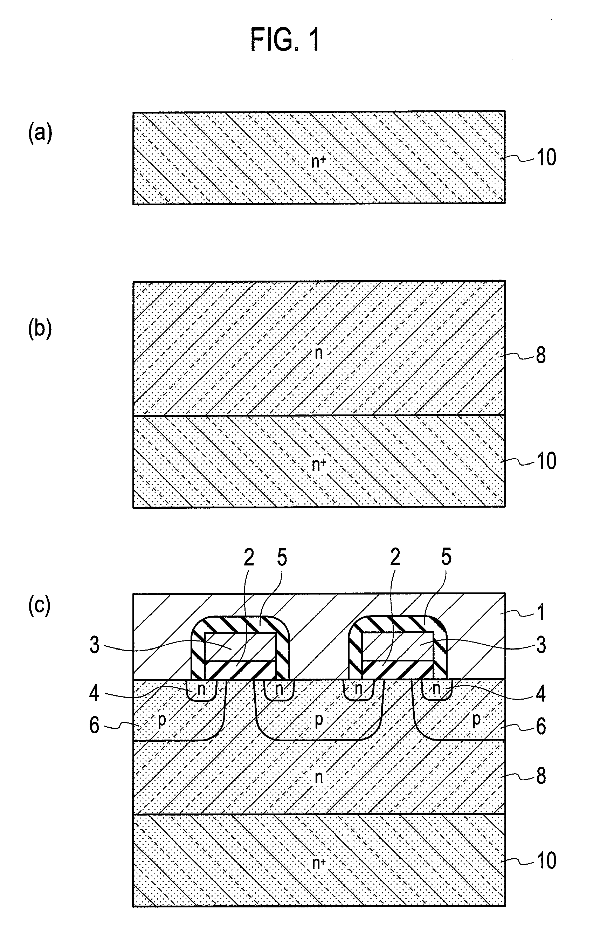

[Fig. 1] It is a drawing showing one process for a fabrication method for a semiconductor device according to a first embodiment of the present invention;
   (a) A schematic cross-sectional configuration diagram showing a process for preparing a semiconductor substrate 10,
   (b) A schematic cross-sectional configuration diagram showing a process for forming an n type epitaxial growth layer 8 on the semiconductor substrate 10, and
   (c) A schematic cross-sectional configuration diagram showing a structure in which n channel MOS FETs of a planar structure are formed on the surface of the n type epitaxial growth layer 8.

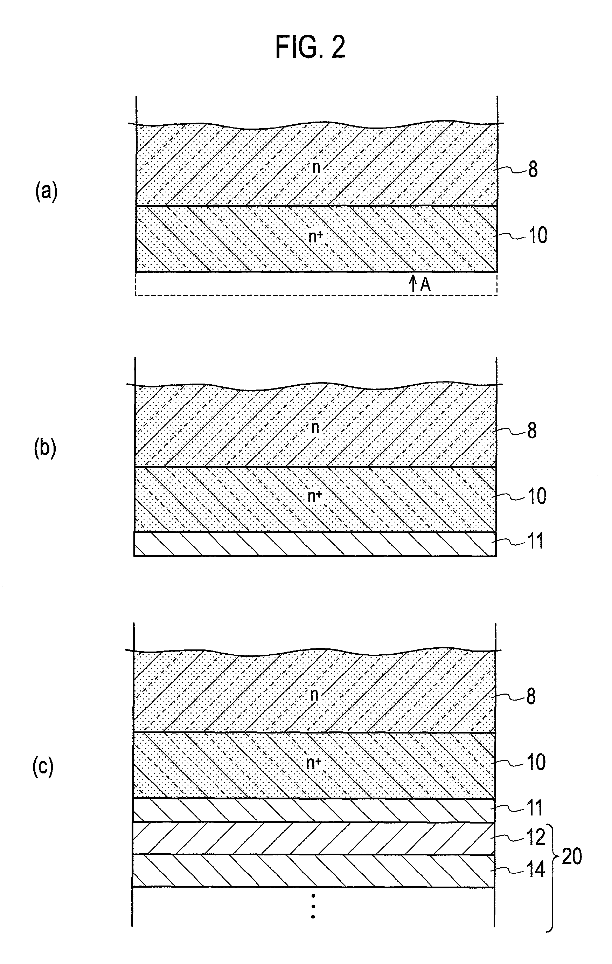

[Fig. 2] It is a drawing showing one process for the fabrication method for the semiconductor device according to the first embodiment of the present invention;
   (a) A partial schematic cross-sectional configuration diagram showing a process for a wafer thinning by polishing the semiconductor substrate 10 from a back side after the process of Fig. 1(a),
   (b) A partial schematic cross-sectional configuration diagram showing a process for forming a metal layer 11 on the polished back side of the semiconductor substrate 10, and
   (c) A partial schematic cross-sectional configuration diagram showing a process for forming a metal laminate structure 20 composed of a metal layer 12, a metal layer 14, ..., on the surface of the metal layer 11.

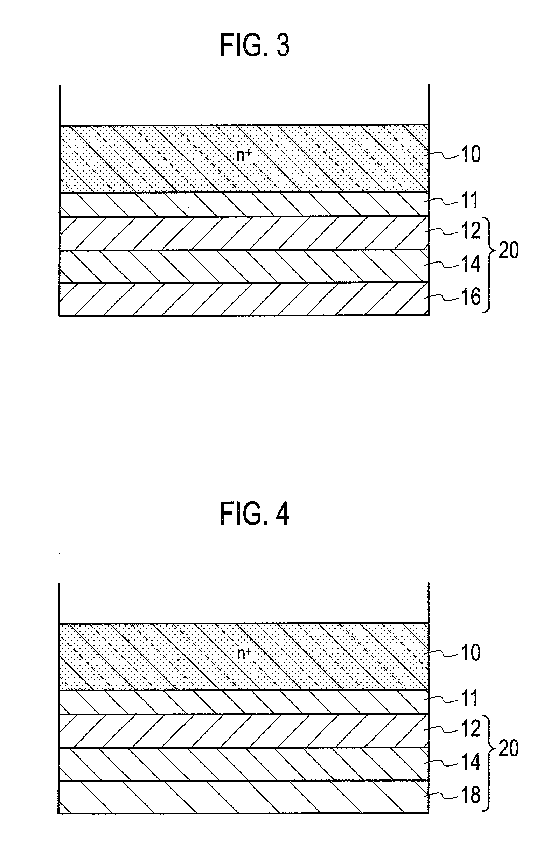

[Fig. 3] It is a drawing showing one process for the fabrication method for the semiconductor device according to the first embodiment of the present invention, and is a partial schematic cross-sectional configuration diagram showing a process for forming the metal layer 12, the metal layer 14, and a metal layer 16 on the surface of the metal layer 11 one after another in one process of Fig. 2(c).
[Fig. 4] It is a drawing showing one process for a fabrication method for a semiconductor device according to a modified example 1 of the first embodiment of the present invention, and is a partial schematic cross-sectional configuration diagram showing a process for forming the metal layer 12, the metal layer 14, and a metal layer 18 on the surface of the metal layer 11 one after another in one process of Fig. 2(c).

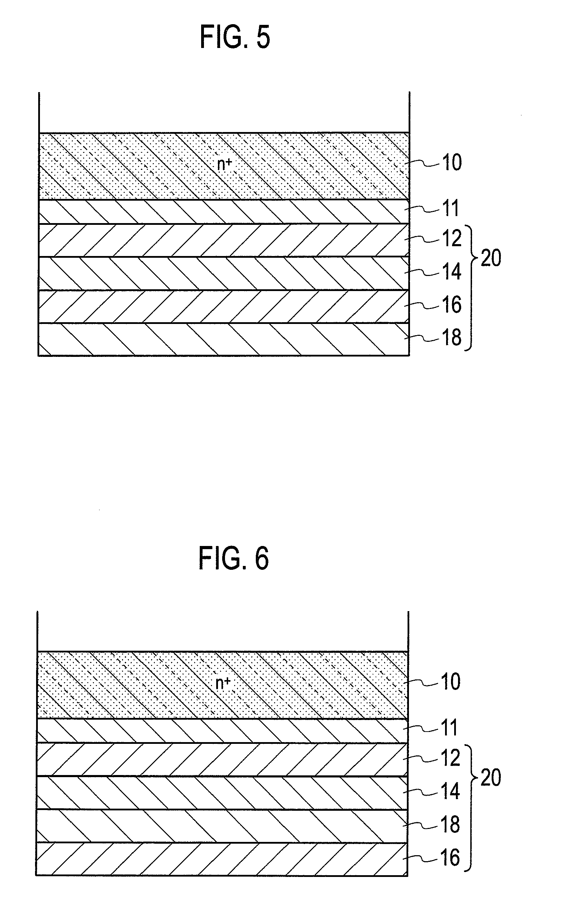

[Fig. 5] It is a drawing showing one process for a fabrication method for a semiconductor device according to a modified example 2 of the first embodiment of the present invention, and is a partial schematic cross-sectional configuration diagram showing a process for forming the metal layer 12, the metal layer 14, the metal layer 16, and the metal layer 18 on the surface of the metal layer 11 one after another in one process of Fig. 2(c).
[Fig. 6] It is a drawing showing one process for a fabrication method for a semiconductor device according to a modified example 3 of the first embodiment of the present invention, and is a partial schematic cross-sectional configuration diagram showing a process for forming the metal layer 12, the metal layer 14, the metal layer 18, and the metal layer 16 on the surface of the metal layer 11 one after another in one process of Fig. 2(c).
[Fig. 7]
   (a) A schematic circuit configuration diagram of an MOSFET according to a comparative example of the present invention, and
   (b) A schematic cross-sectional configuration diagram of an MOSFET according to the comparative example of the present invention.
[Fig. 8]
   (a) A schematic circuit configuration diagram of the semiconductor device according to the first embodiment of the present invention, and
   (b) A schematic cross-sectional configuration diagram of the semiconductor device according to the first embodiment of the present invention.
[Fig. 9]
   (a) A configuration diagram of a basic circuit including an FRD between a drain terminal D and a source terminal S, and
   (b) A cross-sectional configuration diagram of a basic element structure including the FRD between the drain terminal D and the source terminal S, in the semiconductor device according to the first embodiment of the present invention.

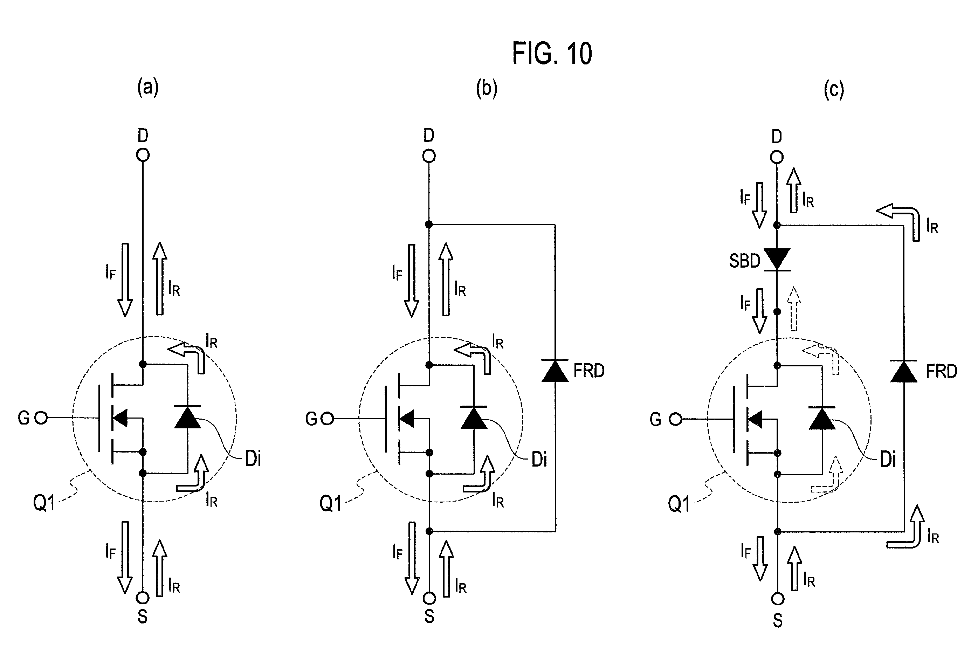

[Fig. 10] It is a circuit configuration diagram of a semiconductor device applied to an inverter circuit;
   (a) An example of an MOSFET including a parasitic diode Di,
   (b) A circuit configuration diagram of the semiconductor device applied to an inverter circuit, and an example of an MOSFET including the parasitic diodes Di and the FRD, and
   (c) A circuit configuration diagram of the semiconductor device according to the first embodiment of the present invention, and an example of an MOSFET including a suspended body diode (SBD), the parasitic diode Di, the FRD, and a Schottky diode.
[Fig. 11] It is a comparative diagram between the forward characteristic (I_{F}-V_{F}) of the semiconductor device (SBDMOSFET) according to the first embodiment of the present invention, and an MOSFET and an MOSFET+FRD.
[Fig. 12] It is a comparative diagram showing the relation between on resistance R_{DS} (on) (Ω) and forward voltage V_{F}(V) of the semiconductor device (SBDMOSFET) according to the first embodiment of the present invention, an MOSFET and an MOSFET+FRD.
[Fig. 13] It is an example of a reverse recovery waveform of an MOSFET.
[Fig. 14] It is an example of a reverse recovery waveform of the semiconductor device (SBDMOSFET) according to the first embodiment of the present invention.
[Fig. 15] It is a half bridge inverter circuit for driving a CCFL to which the semiconductor device according to the first embodiment of the present invention is applied;
   (a) An operation explanatory diagram in the state where an MOS transistor QA is turned ON and a forward current I_{F} flows in a load inductance L,
   (b) An operation explanatory diagram in the state where the MOS transistor QA is turned OFF and a reverse recovery current I_{R} flows in the load inductance L through the FRD of an MOS transistor QB,
   (c) An operation explanatory diagram in the state where the MOS transistor QB is turned OFF and the reverse recovery current I_{R} flows in the load inductance L through the FRD of the MOS transistor QA, and
   (d) An operation explanatory diagram in the state where the MOS transistor QB is turned ON and the forward current I_{F} flows in the load inductance L.

### REFERENCE SIGNS LIST

1: Source electrode;
2: Gate insulating film;
3: Gate electrode;
4: Source layer;
5: Interlayer insulating film;
6: Base layer;
8: Epitaxial growth layer;
9: AuSb layer;
10: Semiconductor substrate;
11, 12, 14, 16, and 18: Metal layer; and
20: Metal laminate structure.

### BEST MODE FOR CARRYING OUT THE INVENTION

Next, an embodiment of the invention is described with reference to drawings. In the following drawings, the same or similar reference numeral is attached to the same or similar part in order to avoid duplicating of explanation, and the same reference numerals are attached to some layers and those underlying regions in order to make the explanation simple. However, a drawing is schematic and it should care about differing from an actual thing. Drawings are schematic, not actual, and may be inconsistent in between in scale, ratio, etc.

The embodiment shown in the following exemplifies the device and the method for materializing the technical idea of the invention, and the technical idea of the invention does not specify assignment of each component parts, etc. as the following. Various changes can be added to the embodiments of the invention in scope of claims.

### [First Embodiment]

### (Element Structure)

As shown in Fig. 1, a semiconductor device according to a first embodiment of the present invention includes: a semiconductor substrate 10 having a first conductivity type and forming a drain layer; a base layer 6 disposed on the surface of the semiconductor substrate 10 and having a second conductivity type; a source layer 4 disposed on the base layer 6 and having the first conductivity type; a gate insulating film 2 disposed on the base layer 6 and the source layer 4; a gate electrode 3 disposed on the gate insulating film 2; and a source electrode 1 connected to the base layer 6 and the source layer 4. Moreover, as shown in Fig. 2 to Fig. 3, the semiconductor device according to the first embodiment includes: a metal layer 11 disposed on the back side of the semiconductor substrate 10 and subjected to alloy process with the semiconductor substrate 10; a metal layer 12 disposed on the metal layer 11; a metal layer 14 disposed on the metal layer 12; and a metal layer 16 disposed on the metal layer 14. In addition, an interlayer insulating film 5 is disposed surrounding the gate electrode 3.

Moreover, as shown in Fig. 1, the semiconductor device according to the first embodiment may include an epitaxial growth layer 8 disposed on the surface of the semiconductor substrate 10 and having the first conductivity type. In this case, as shown in Fig. 1, the semiconductor device according to the first embodiment includes: the semiconductor substrate 10 having the first conductivity type and forming the drain layer; the epitaxial growth layer 8 disposed on the surface of the semiconductor substrate 10 and having the first conductivity type; the base layer 6 disposed on the epitaxial growth layer 8 and having the second conductivity type; the source layer 4 disposed on the base layer 6 and having the first conductivity type; the gate insulating film 2 disposed on the epitaxial growth layer 8, the base layer 6, and the source layer 4; the gate electrode 3 disposed on the gate insulating film 2, and the source electrode 1 connected to the base layer 6 and the source layer 4.

Moreover, as shown in Fig. 3, the metal layer 11 may be formed of a first Au layer, the metal layer 12 may be formed of a Ti layer or a Cr layer, the metal layer 14 may be formed of a Ni layer, and the metal layer 16 may be formed of a second Au layer.

As shown in Fig. 1 to Fig. 3, in the rear electrode configuration at the drain side of the n channel vertical MOSFET, the semiconductor device according to the first embodiment forms the first Au layer on the n type silicon semiconductor substrate 10 as the metal layer 11 which is not doped with the impurities, such as Sb and As, and, after an alloy process with the n⁺ type silicon semiconductor substrate 10, forms the metal laminate structure 20 including the metal layer 12 composed of the Ti layer or Cr layer for an assembly, the metal layer 14 composed of a Ni layer, and the metal layer 16 composed of the second Au layer.

The semiconductor device according to the first embodiment forms a Schottky diode by forming the above-mentioned metal laminate structure 20 (12, 14, and 16) on the n⁺ type silicon semiconductor substrate 10, in the rear electrode configuration at the drain side of the n channel vertical MOSFET. The Schottky diode is called an SBD (Suspended Body Diode) since the Schottky diode is connected to the drain layer of the n channel vertical MOSFET. In this case, the metal laminate structure 20 functions as an anode of the Schottky diode, and the n⁺ type silicon semiconductor substrate 10 acting as the drain layer of the n channel vertical MOSFET functions as a cathode of the Schottky diode.

### (Modified Example 1)

As for a semiconductor device according to a modified example 1 of the first embodiment, the configuration of the metal laminate structure 20 is only differing from the semiconductor device according to the semiconductor device according to the first embodiment, and other configurations are the same as that of the semiconductor device according to the first embodiment. That is, as shown in Fig. 4, the metal layer 11 disposed at the back side of the silicon semiconductor substrate 10 is formed of a first Au layer subjected to the alloy process with the silicon semiconductor substrate 10, the metal layer 12 disposed on the metal layer 11 is formed of a Ti layer or a Cr layer, the metal layer 14 disposed on the metal layer 12 is formed of a Ni layer, and the metal layer 18 disposed on the metal layer 14 is formed of a Ag layer.

### (Modified Example 2)

As for a semiconductor device according to a modified example 2 of the first embodiment, the configuration of the metal laminate structure 20 is only differing from the semiconductor device according to the semiconductor device according to the first embodiment, and other configurations are the same as that of the semiconductor device according to the first embodiment. That is, as shown in Fig. 5, the metal layer 11 disposed at the back side of the silicon semiconductor substrate 10 is formed of a first Au layer subjected to the alloy process with the silicon semiconductor substrate 10, the metal layer 12 disposed on the metal layer 11 is formed of a Ti layer or a Cr layer, the metal layer 14 disposed on the metal layer 12 is formed of a Ni layer, the metal layer 16 disposed on the metal layer 14 is formed of a second Au layer, and the metal layer 18 disposed on the metal layer 16 is formed of a Ag layer.

### (Modified Example 3)

As for a semiconductor device according to a modified example 3 of the first embodiment, the configuration of the metal laminate structure 20 is only differing from the semiconductor device according to the semiconductor device according to the first embodiment, and other configurations are the same as that of the semiconductor device according to the first embodiment. That is, as shown in Fig. 6, the metal layer 11 disposed at the back side of the silicon semiconductor substrate 10 is formed of a first Au layer subjected to the alloy process with the silicon semiconductor substrate 10, the metal layer 12 disposed on the metal layer 11 is formed of a Ti layer or a Cr layer, the metal layer 14 disposed on the metal layer 12 is formed of a Ni layer, the metal layer 18 disposed on the metal layer 14 is formed of a Ag layer, and the metal layer 16 disposed on the metal layer 18 is formed of a second Au layer.
In the semiconductor device according to the first embodiment and its modified examples, the n channel MOS FET of the vertical structure may be provided with the planar gate structure, or may be provided with the vertical trench gate structure.

In the semiconductor device according to the first embodiment and its modified examples, the high forward voltage (V_{F}) characteristics which can cut off only the reverse regenerative current can be realized without influencing on the forward current by forming the metal layer 11 composed of a Au layer instead of a AuSb layer or a AuAs layer on the surface of the n type silicon semiconductor substrate 10.

Moreover, according to the semiconductor device according to the first embodiment and its modified examples, in the rear electrode configuration at the drain side of the n channel vertical MOSFET, the first Au layer is formed on the n type silicon semiconductor substrate 10 as the metal layer 11 which is not doped with the impurities, such as Sb or As, etc., and, after the alloyprocess with the n⁺ type silicon semiconductor substrate 10, the metal laminate structure 20 composed of the metal layer 12 composed of the Ti layer or Cr layer for the assembly, the metal layer 14 composed of the Ni layer, the metal layer 16 composed of the second Au layer, the metal layer 18 composed of the Ag layer, etc. is formed as a satisfactory layered structure without a problem of removal of rear electrode structure.

### (Fabrication Method)

A drawing showing one process for the fabrication method for the semiconductor device according to the first embodiment, and showing a schematic cross-section structure showing a process for preparing the semiconductor substrate 10 is expressed as shown in Fig. 1(a). Moreover, a schematic cross-section structure showing a process for forming the n type epitaxial growth layer 8 on the semiconductor substrate 10 is expressed as shown in Fig. 1(b). Furthermore, a schematic cross-section structure showing a structure in which the n channel MOS FET of a planar structure is formed on the surface of the n type epitaxial growth layer 8 is expressed as shown in Fig. 1(c).

A partial schematic cross-section structure showing a process for a wafer thinning by polishing the semiconductor substrate 10 from a back side after the process of Fig. 1(c) is expressed as shown in Fig . 2(a). Moreover, a partial schematic cross-section structure showing a process for forming the metal layer 11 on the polished back side of the semiconductor substrate 10 is expressed as shown in Fig. 2(b).

Furthermore, a partial schematic cross-section structure showing a process for forming the metal laminate structure 20 composed of the metal layer 12, the metal layer 14, ..., on the surface of the metal layer 11 is expressed as shown in Fig. 2(c).

Furthermore, in one process of Fig. 2(c), a partial schematic cross-section structure showing a process for forming the metal layer 12, the metal layer 14, and the metal layer 16 on the surface of the metal layer 11 one after another is expressed as shown in Fig. 3.

As shown in Fig. 1 to Fig. 3, the fabrication method for the semiconductor device according to the first embodiment includes: the step of preparing the semiconductor substrate 10 having the first conductivity type and acting as a drain layer; the step of forming the base layer 6 having the second conductivity type on the surface of the semiconductor substrate 10; the step of forming the source layer 4 having the first conductivity type on the base layer 6; the step of forming the gate insulating film 2 on the base layer 6 and the source layer 4; the step of forming the gate electrode 3 on the gate insulating film 2; the step of forming the source electrode 1 connected to the base layer 6 and the source layer 4; the step of forming the metal layer 11 subjected to the alloy process with the semiconductor substrate 10 on the back side of the semiconductor substrate 10; the step of forming the metal layer 12 on the metal layer 11; the step of forming the metal layer 14 on the metal layer 12; and the step of forming the metal layer 16 on the metal layer 14.

The metal layer 11 is formed by the first Au layer, the metal layer 12 is formed by the Ti layer or the Cr layer, the metal layer 14 is formed by the Ni layer, and the metal layer 16 is formed by the second Au layer.

Hereinafter, about the fabrication method for the semiconductor device according to the first embodiment, its example will be explained in detail.

(a) First of all, as shown in Fig. 1(a), the n⁺ type silicon semiconductor substrate 10 by which P, As, Sb, or Bi, etc. are doped is prepared. Since the surface orientation can make the degree of electron mobility high, for example when achieving the MOSFET of the planer gate structure, a (100) plane is preferable. The impurity concentration is about 1×10¹⁷ to 10²¹ cm⁻³, for example.

(b) Next, as shown in Fig. 1(b), the n type epitaxial growth layer 8 is formed on the n⁺ type silicon semiconductor substrate 10. The impurity concentration is about 1×10¹⁵ to 10¹⁷ cm⁻³, for example.

(c) Next, as shown in Fig. 1(c), an each part of the regions needed for achieving the MOSFET of the planer gate structure is formed on the n type epitaxial growth layer 8.

(c-1) For example, the gate electrode 3 composed of a polysilicon layer etc. is formed after forming the gate insulating film 2 on the n type epitaxial growth layer 8 by a thermal oxidation etc.

(c-2) Next, the p type base layer 6 and the n type source layer 4 is formed by an ion implantation technology after patterning the gate insulating film 2 and the gate electrode 3.The ion, such as B, Al, Ga, or In, etc., can be used as the impurity ion for forming the p type base layer 6. Moreover, the ion, such as P, As, Sb, or Bi, etc., can be used as the impurity ion for forming the n type source layer 4. The accelerating energy and the amount of dosage can be determined according to the diffusing depth and the impurity concentration profile of the each layer.

(d) Next, as shown in Fig. 2(a), the n⁺ type silicon semiconductor substrate 10 is polished from a back side to a predetermined thickness by using a CMP (Chemical Mechanical Polishing)technology.

In Fig. 2(a), the dotted line part shown by the arrow A shows schematically the polished region of the n⁺ type silicon semiconductor substrate 10.

(e) Next, as shown in Fig. 2(b), the metal layer 11 composed of the Au layer is formed on the polished back side of the n⁺ type silicon semiconductor substrate 10 by a sputtering technology or a vacuum evaporation technology. The impurities, such as As or Sb, etc. , are not doped in the metal layer 11 formed here at all. That is, neither the AuAs layer nor the AuSb layer is formed. The thickness of the metal layer 11 is about 10 nm, for example.

(f) Next, as shown in Fig. 2(b), the metal layer 11 is subjected to the alloy process with the n⁺ type silicon semiconductor substrate 10. The temperature conditions of the alloy process are about 300 degrees C to about 500 degrees C, for example.

(g) Next, as shown in Fig. 2(c), the metal laminate structure 20 is formed on the metal layer 11. The state where the metal layer 12 composed of the Ti layer or the Cr layer is formed on the metal layer 11, and also the metal layer 14 composed of the Ni layer is formed on the metal layer 12 is shown in the example of Fig. 2(c). The metal layer 12 composed of the Ti layer or the Cr layer functions as a barrier metal for bonding between the metal layer 11 and the subsequent metal layer 14 composed of the Ni layer. Both of the metal layer 12 and the metal layer 14 can be formed by a sputtering technology or a vacuum evaporation technology. In this case, the thickness of the metal layer 12 is about 70 nm, for example, and the thickness of the metal layer 14 is about 600 nm, for example.

(h) Next, as shown in Fig. 3, the metal layer 16 composed of the second Au layer is formed on the metal layer 14. The metal layer 16 can also be formed by a sputtering technology or a vacuum evaporation technology. The thickness of the metal layer 16 is about 300 nm, for example.

In the semiconductor device according to the first embodiment, as shown in Fig. 3, the metal laminate structure 20 is formed of the layered structure of the metal layer 14/metal layer 12/metal layer 16 composed of the Ti layer or Cr layer/Ni layer/second Au layer.

### (Modified Example 1)

In one process of Fig. 2(c), a partial schematic cross-section structure showing a process for forming the metal layer 12 composed of the Ti layer or the Cr layer, the metal layer 14 composed of the Ni layer, and the metal layer 18 composed of the Ag layer on the surface of the metal layer 11 composed of the Au layer one after another is expressed as shown in Fig. 4. The metal layer 18 can also be formed by a sputtering technology or a vacuum evaporation technology.

In the semiconductor device according to the modified example 1 of the first embodiment, as shown in Fig. 4, the metal laminate structure 20 is formed of the layered structure of the metal layer 14/metal layer 12/metal layer 18 composed of the Ti layer or Cr layer/Ni layer/Ag layer.

### (Modified Example 2)

In one process of Fig. 2(c), a partial schematic cross-section structure showing a process for forming the metal layer 12 composed of the Ti layer or the Cr layer, the metal layer 14 composed of the Ni layer, the metal layer 16 composed of the second Au layer, and the metal layer 18 composed of the Ag layer on the surface of the metal layer 11 composed of the first Au layer one after another is expressed as shown in Fig. 5.

In the semiconductor device according to the modified example 2 of the first embodiment, as shown in Fig. 5, the metal laminate structure 20 is formed of the layered structure of the metal layer 16/metal layer 14/metal layer 12/metal layer 18 composed of the Ti layer or Cr layer/Ni layer/Au layer/Ag layer.

### (Modified Example 3)

In one process of Fig. 2(c), a partial schematic cross-section structure showing a process for forming the metal layer 12 composed of the Ti layer or the Cr layer, the metal layer 14 composed of the Ni layer, the metal layer 18 composed of the Ag layer, and the metal layer 16 composed of the Au layer on the surface of the metal layer 11 composed of the Au layer one after another is expressed as shown in Fig. 6.

In the semiconductor device according to the modified example 3 of the first embodiment, as shown in Fig. 6, the metal laminate structure 20 is formed of the layered structure of the metal layer 18/metal layer 14/metal layer 12/metal layer 16 composed of the Ti layer or Cr layer/Ni layer/Ag layer/Au layer.

### (Comparative Example)

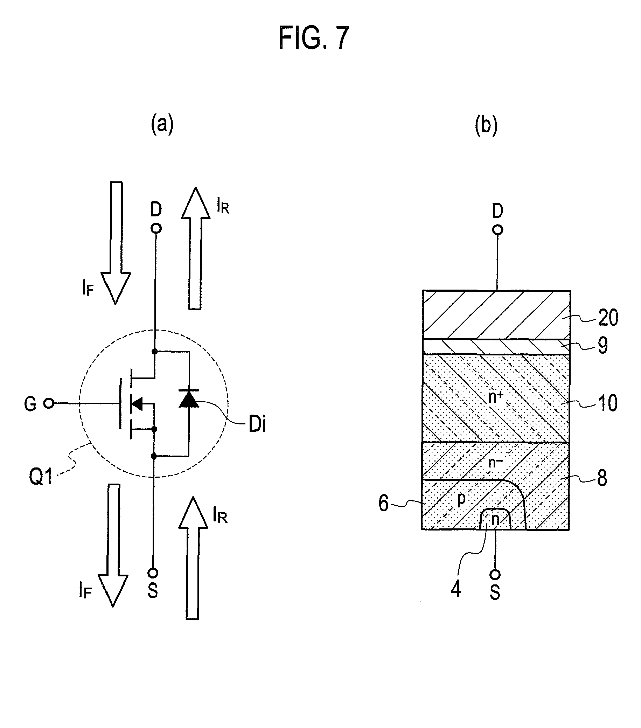

A schematic circuit configuration of MOSFET according to a comparative example of the present invention is expressed as shown in Fig. 7(a). Moreover, a schematic cross-section structure of the MOSFET according to the comparative example is expressed as shown in Fig. 7(b).

As for the MOSFET according to the comparative example of the present invention, as shown in Fig. 7 (b), a AuSb layer 9 is formed on the n⁺ silicon semiconductor substrate 10, and the n+ silicon semiconductor substrate 10 and the AuSb layer 9 are alloyed by the alloy process. Furthermore, a metal laminate structure 20 is provided on the AuSb layer 9. Since the n⁺ silicon semiconductor substrate 10 and the AuSb layer 9 are alloyed by the alloy process, an ohmic contact is formed in the electrode structure at the drain side of the MOSFET according to the comparative example of the present invention.

On the circuit configuration, as shown in Fig. 7(a), a parasitic diode Di is formed by the structure of a p base layer 6/an n⁻ type epitaxial growth layer 8/an n⁺ silicon semiconductor substrate 10, a forward current I_{F} flows between the drain terminal D and the source terminal S in the ON state of the vertical MOSFET, and a reverse recovery current I_{R} flows via the parasitic diode Di in the OFF state of the vertical MOSFET.

### (A Basic Circuit and A Basic Element Structure)

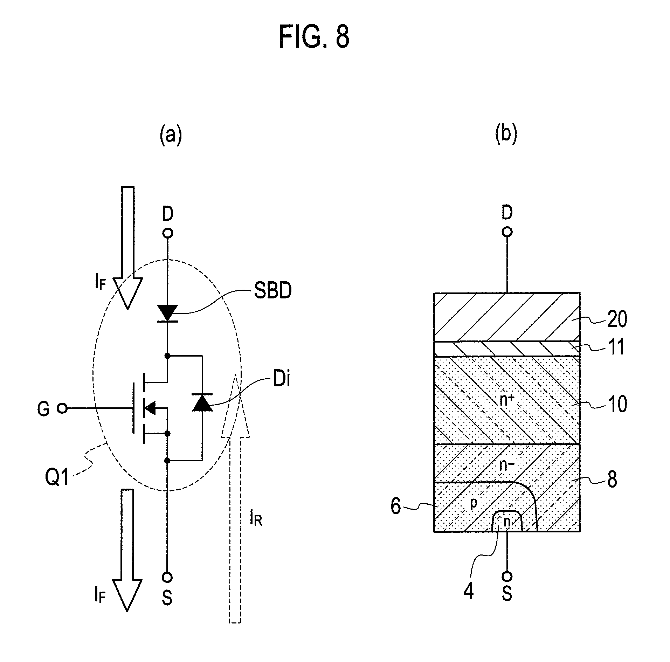

A schematic circuit configuration of the semiconductor device according to the first embodiment is expressed as shown in Fig. 8(a). Moreover, a schematic cross-section structure of the semiconductor device according to the first embodiment is expressed as shown in Fig. 8(b).

As for the semiconductor device according to the first embodiment, as shown in Fig. 8(b), the metal layer 11 composed of the Au layer is formed on the n⁺ silicon semiconductor substrate 10, and the n⁺ silicon semiconductor substrate 10 and the metal layer 11 are subjected to the alloy process. Furthermore, the metal laminate structure 20 is provided on the metal layer 11. The metal laminate structure 20 includes various kinds of structural examples as shown in Fig. 3 to Fig. 6, for example.

As shown in Fig. 8(a) and Fig. 8(b), as for the semiconductor device according to the first embodiment, a Schottky diode is formed by disposing the metal laminate structure 20 on the n⁺ type silicon semiconductor substrate 10, in the rear electrode configuration at the drain side of the n channel vertical MOSFET. The Schottky diode is an SBD connected to the drain layer of the n channel vertical MOSFET. The cathode of the Schottky diode is connected to the drain of the vertical MOSFET, and the anode of the Schottky diode is connected to the drain terminal D. Moreover, the source of the vertical MOSFET is connected to the source terminal S.

On the circuit configuration, as shown in Fig. 8(a), the parasitic diode Di is formed by the structure composed of the p base layer 6/the n⁻ type epitaxial growth layer 8/the n⁺ silicon semiconductor substrate 10.

Therefore, in the ON state of the vertical MOSFET, a forward current I_{F} flows between the drain terminal D and the source terminal S connected to the anode of the Schottky diode. However, in the OFF state of the vertical MOSFET, since the Schottky diode is formed between the drain layer (the n⁺ silicon semiconductor substrate 10) and the drain terminal D of the vertical MOSFET, the reverse recovery current I_{R} does not flow through the parasitic diode Di.

### (A Basic Circuit and A Basic Element Structure Including An FRD)

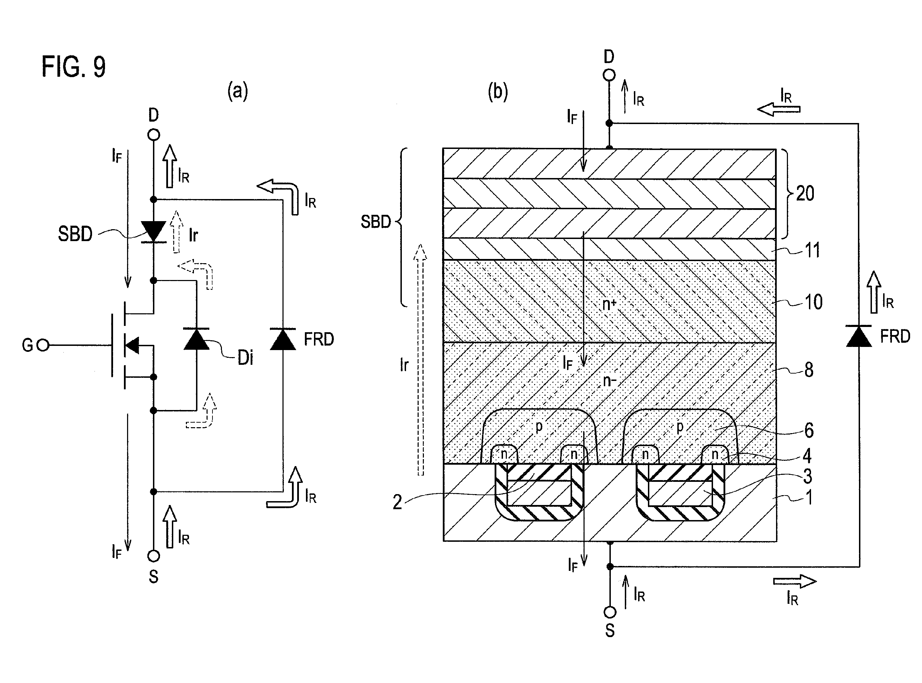

In the semiconductor device according to the first embodiment, a configuration of a basic circuit including an FRD between the drain terminal D and the source terminal S is expressed as shown in Fig. 9(a).

Moreover, a cross-section structure of a basic element structure including the FRD between the drain terminal D and the source terminal S is expressed as shown in Fig. 9(b). Fig. 9(a) and Fig. 9(b) show the details of the reverse recovery current Iᵣ flowing through the SBD, the reverse recovery current I_{R} flowing through the FRD, and the forward current I_{F} flowing through the MOSFET.

As for the MOSFET according to the first embodiment, the metal layer 11 composed of the Au layer is formed on the n⁺ silicon semiconductor substrate 10, and the n⁺ silicon semiconductor substrate 10 and the metal layer 11 are subjected to the alloy process, as shown in Fig. 9(b). Furthermore, the metal laminate structure 20 is provided on the metal layer 11. The metal laminate structure 20 includes various kinds of structural examples as shown in Fig. 3 to Fig. 6, for example.

The Schottky diode is formed between the drain layer (the n⁺ silicon semiconductor substrate 10) and the drain terminal D of the vertical MOSFET, and the forward current I_{F} flows between the drain terminal D and the source terminal S of the semiconductor device in the ON state of the vertical MOSFET. However, in the OFF state of the vertical MOSFET, since the Schottky diode is disposed between the drain layer (n⁺ silicon semiconductor substrate 10) and drain terminal D of the vertical MOSFET, the reverse recovery current Iᵣ hardly flows through the parasitic diode Di, and the reverse recovery current I_{R} flows through the FRD connected between the drain terminal D and the source terminal S of the semiconductor device.

That is, the value of the forward voltage V_{f} of the parasitic diode Di of the MOSFET becomes larger than the value of the forward voltage V_{F} of the FRD connected to the semiconductor device in parallel. Accordingly, the reverse recovery current (the regenerative current) I_{R} flows through the FRD, and the parasitic loss in the parasitic diode Di is reduced.

### (I_{F}-V_{F} Forward Characteristic)

Fig. 10(a) shows a circuit configuration diagram of a semiconductor device applied to an inverter circuit, and shows an example of an MOSFET including the parasitic diode Di. Moreover, an example of an MOSFET including the parasitic diode Di and the FRD is expressed as shown in Fig. 10(b).

On the other hand, Fig. 10(c) shows a circuit configuration diagram of the semiconductor device according to the first embodiment, and shows an example of an MOSFET including the parasitic diode Di, the FRD, and the SBD.

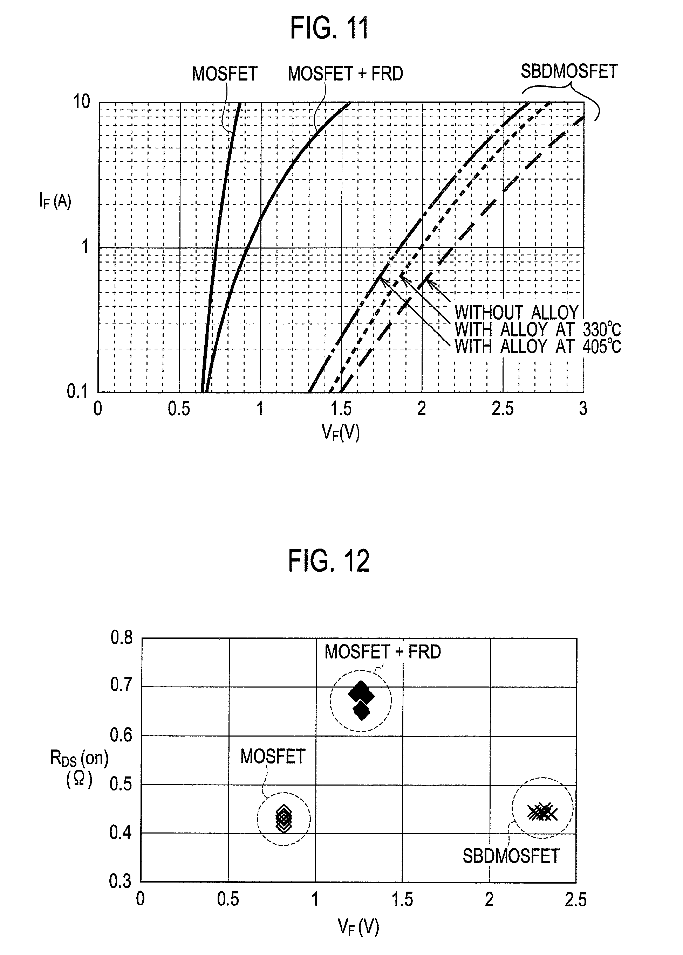

A comparative diagram of the forward characteristic (I_{F}-V_{F}) of the semiconductor device (SBDMOSFET) according to the first embodiment and the MOSFET and the MOSFET+FRD is expressed as shown in Fig. 11.

In the semiconductor device (SBDMOSFET) according to the first embodiment, the alloy conditions of the metal layer 11 composed of the Au layer are implemented, for example at 300 degrees C to 500 degrees C. Fig. 11 shows the I_{F}-V_{F} forward characteristic in each semiconductor device (SBDMOSFET) in the case of without the alloy process, the case where the temperature at the alloy process are 330 degrees C, and the case where the temperature at alloy process are 405 degrees C. In Fig. 11, the curve expressed by "MOSFET" shows the I_{F}-V_{F} forward characteristic of the MOSFET having the circuit structure of Fig. 10 (a). Moreover, the curve expressed by "MOSFET+FRD" shows the I_{F}-V_{F} forward characteristic of the MOSFET+FRD having the circuit structure of Fig. 10(b). Moreover, the curve expressed by "SBDMOSFET" shows the I_{F}-V_{F} forward characteristic of the SBDMOSFET having the circuit structure of Fig. 10(c).

A result shown in Fig. 11 proves that the forward voltage V_{F}(V) on the I_{F}-V_{F} forward characteristic is rising in an sequence of the MOSFET, the MOSFET+FRD, and the SBDMOSFET. Moreover, it changes also with the alloy conditions of the metal layer 11 composed of the Au layer, and is rising in order in case of without alloy processing, the case where the temperature at alloy process is 330 degrees C, and the case where the temperature at alloy process is 405 degrees C.

### (On Resistance Characteristics)

A comparative diagram showing the relation between the on resistance R_{DS}(on) (Ω) and the forward voltage V_{F} (V) of the semiconductor device (SBDMOSFET) according to the first embodiment, the MOSFET, and the MOSFET+FRD is expressed as shown in Fig. 12. The value of the forward current IF is based on the case at a standard value of 5 (A).

As clearly seen from Fig. 12, it is proved that the on resistance R_{DS}(on) (Ω) of the semiconductor device (SBDMOSFET) according to the first embodiment is about 0.45 Ω of the same grade as the MOSFET, and is about 30% lower than the value of about 0.65 Ω of the on resistance R_{DS}(on) (Ω) of the MOSFET+FRD.

### (Example of Reverse Recovery Characteristics)

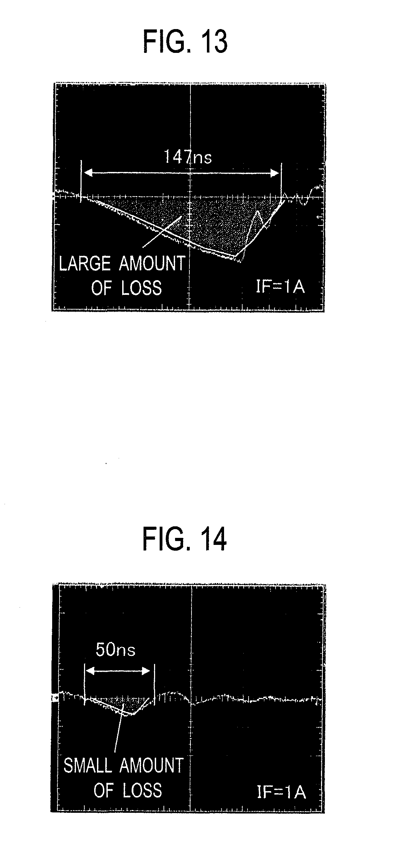

An example of the reverse recovery waveform of the MOSFET is expressed as shown in Fig. 13. Fig. 13 shows the aspect that the amount of the reverse recovery loss is large in accompanying with the parasitic loss of the parasitic diode Di.

On the other hand, an example of the reverse recovery waveform of the semiconductor device (SBDMOSFET) according to the first embodiment is expressed as shown in Fig. 14. In Fig. 14, since the reverse recovery current I_{R} hardly flows through the parasitic diode Di in the reverse recovery state, there is almost no parasitic loss in the parasitic diode Di, and also the amount of the reverse recovery loss becomes small.

### (A Half Bridge Inverter Circuit for Driving A CCFL)

The semiconductor device according to the first embodiment and its modified examples can be applied for an electric appliance with an inductive load. As an example of the electric appliance with an inductive load, there are a back light inverter circuit of an LCD (liquid crystal display), an inverter circuit for air-conditioners, and an inverter circuit for driving for a lighting device, etc.

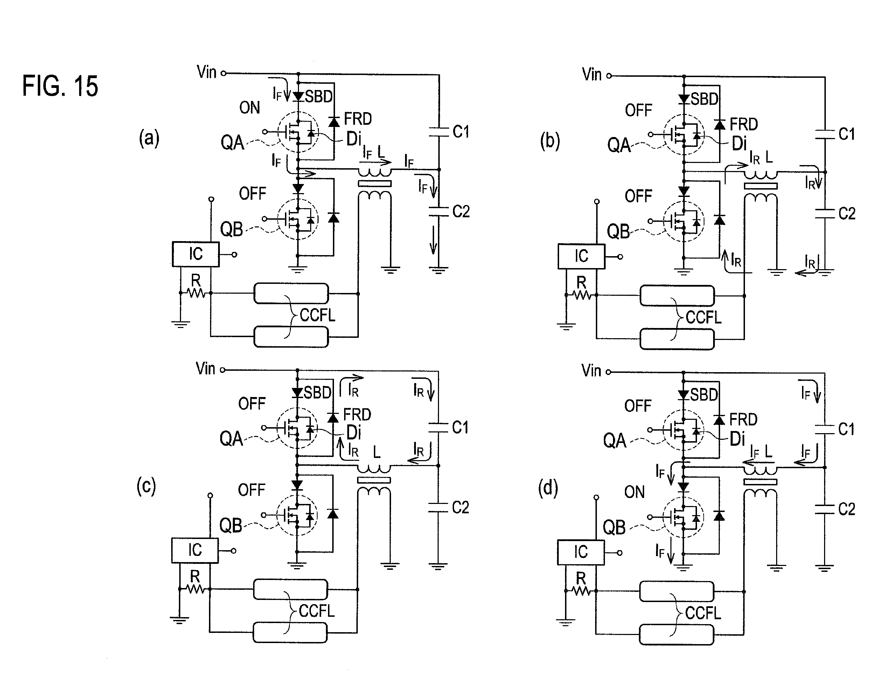

An operation of a half bridge inverter circuit for driving the CCFL to which the semiconductor device according to the first embodiment is applied is expressed as shown in Fig. 15.

An operation explanatory diagram in the state where an MOS transistor QA is turned ON and a forward current IF flows through a load inductance L is expressed as shown in Fig. 15(a).

An operation explanatory diagram in the state where the MOS transistor QA is turned OFF and a reverse recovery current I_{R} flows through the load inductance L via an FRD of an MOS transistor QB is expressed as shown in Fig. 15(b).

An operation explanatory diagram in the state where the MOS transistor QB is turned OFF and the reverse recovery current I_{R} flows through the load inductance L via the FRD of MOS transistor QA is expressed as shown in Fig. 15(c).

An operation explanation in the state where the MOS transistor QB is turned ON and the forward current I_{F} flows through the load inductance L is expressed as shown in Fig. 15(d).

As shown in Fig. 15, the half bridge inverter circuit for driving the CCFL to which the semiconductor device according to the first embodiment is applied composes an SBD-MOSFET QA and an SBD-MOSFET QB in a half bridge, and includes the CCFL combined with the load inductance L. The CCFL is connected to a control IC. A series circuit of capacitors C1 and C2 is connected between a power supply voltage Vin of the half bridge and a ground potential, and charging and discharging operations are repeated in order of Fig. 15(a) => Fig. 15(b) => Fig. 15(d) => Fig. 15(c) => Fig. 15(a) through the load inductance L in accordance with an operation of the half bridge inverter circuit.

In particular, since the loss at the time of the reverse recovery can be reduced by applying the semiconductor device (SBDMOSFET) according to the first embodiment to the half bridge inverter circuit for driving the CCFL, the loss at the time of the reverse recovery of the SBDMOSFET can be reduced as shown in Fig. 15(b) and Fig. 15(d).

According to the semiconductor device and the fabrication method for the semiconductor device of the present invention, the increase of the forward loss can be suppressed and the reverse recovery loss can be reduced.

According to the semiconductor device and the fabrication method for the semiconductor device of the present invention, the mounting area can be reduced by miniaturizing the FRD (Fast Recovery Diode) for cutoff, the increase in the forward loss can be suppressed substantially, and the reverse recovery loss can be reduced, by determining the value of the forward voltage V_{f} of the parasitic diode Di of MOSFET larger than the value of the forward voltage V_{F} of the FRD connected to the semiconductor device in parallel.

### [Other Embodiments]

The present invention has been described by the first embodiment and its modified examples, as a disclosure including associated description and drawings to be construed as illustrative, not restrictive. With the disclosure, artisan might easily think up alternative embodiments, embodiment examples, or application techniques.

Such being the case, the present invention covers a variety of embodiments, whether described or not.

### INDUSTRIAL APPLICABILITY

The semiconductor device of the present invention can be applied to a back light inverter circuit of an LCD (liquid crystal display), an inverter circuit for air-conditioners, and an inverter circuit for driving a lighting device, and is available in whole of n channel vertical MOSFET.

## Claims

1. A semiconductor device comprising:
a semiconductor substrate having a first conductivity type and forming a drain layer;
a base layer disposed on a surface of the semiconductor substrate and having a second conductivity type;
a source layer disposed on the base layer and having the first conductivity type;
a gate insulating film disposed on the semiconductor substrate, the base layer, and the source layer;
a gate electrode disposed on the gate insulating film;
a source electrode connected to the base layer and the source layer;
a first metal layer disposed on a back side of the semiconductor substrate, and subjected to an alloy process with the semiconductor substrate;
a second metal layer disposed on the first metal layer;
a third metal layer disposed on the second metal layer; and
a fourth metal layer disposed on the third metal layer.

2. The semiconductor device according to claim 1, wherein the first metal layer is formed of a first Au layer, the second metal layer is formed of a Ti layer or a Cr layer, the third metal layer is formed of a Ni layer, and the fourth metal layer is formed of a second Au layer.

3. The semiconductor device according to claim 1, wherein the first metal layer is formed of a first Au layer, the second metal layer is formed of a Ti layer or a Cr layer, the third metal layer is formed of a Ni layer, and the fourth metal layer is formed of a Ag layer.

4. The semiconductor device according to claim 1 further comprising a fifth metal layer disposed on the fourth metal layer.

5. The semiconductor device according to claim 4, wherein the first metal layer is formed of a first Au layer, the second metal layer is formed of a Ti layer or a Cr layer, the third metal layer is formed of a Ni layer, the fourth metal layer is formed of a second Au layer, and the fifth metal layer is formed of a Ag layer.

6. The semiconductor device according to claim 4, wherein the first metal layer is formed of a first Au layer, the second metal layer is formed of a Ti layer or a Cr layer, the third metal layer is formed of a Ni layer, the fourth metal layer is formed of a Ag layer, and the fifth metal layer is formed of a second Au layer.

7. A semiconductor device comprising:
an insulated gate field effect transistor comprising
a semiconductor substrate having a first conductivity type and forming a drain layer, a base layer disposed on a surface of the semiconductor substrate and having a second conductivity type,
a source layer disposed on the base layer and having the first conductivity type,
a gate insulating film disposed on the semiconductor substrate, the base layer, and the source layer,
a gate electrode disposed on the gate insulating film, and
a source electrode connected to the base layer and the source layer; and
a metal laminate structure comprising
a second metal layer disposed on a first metal layer disposed on a back side of the semiconductor substrate and subjected to an alloy process with the semiconductor substrate,
a third metal layer disposed on the second metal layer, and
a fourth metal layer disposed on the third metal layer, wherein
the semiconductor device includes a Schottky diode applying the metal laminate structure as an anode, and applying the semiconductor substrate as a cathode.

8. The semiconductor device according to claim 7 further comprising a recovery diode connected in parallel to a series circuit of the insulated gate field effect transistor and the Schottky diode, the recovery diode connecting an anode to the source electrode and connecting a cathode to an anode of the Schottky diode, wherein
a forward voltage of the recovery diode is smaller than a forward voltage of a parasitic diode between the base layer and the semiconductor substrate.

9. The semiconductor device according to claim 8, wherein the first metal layer is formed of a first Au layer, the second metal layer is formed of a Ti layer or a Cr layer, the third metal layer is formed of a Ni layer, and the fourth metal layer is formed of a second Au layer.

10. The semiconductor device according to claim 8, wherein the first metal layer is formed of a first Au layer, the second metal layer is formed of a Ti layer or a Cr layer, the third metal layer is formed of a Ni layer, and the fourth metal layer is formed of a Ag layer.

11. The semiconductor device according to claim 8 further comprising a fifth metal layer disposed on the fourth metal layer.

12. The semiconductor device according to claim 11, wherein the first metal layer is formed of a first Au layer, the second metal layer is formed of a Ti layer or a Cr layer, the third metal layer is formed of a Ni layer, the fourth metal layer is formed of a second Au layer, and the fifth metal layer is formed of a Ag layer.

13. The semiconductor device according to claim 11, wherein the first metal layer is formed of a first Au layer, the second metal layer is formed of a Ti layer or a Cr layer, the third metal layer is formed of a Ni layer, the fourth metal layer is formed of a Ag layer, and the fifth metal layer is formed of a second Au layer.

14. A fabrication method for a semiconductor device comprising:
preparing a semiconductor substrate having a first conductivity type and acting as a drain layer;
forming a base layer having a second conductivity type on a surface of the semiconductor substrate;
forming a source layer having the first conductivity type on the base layer;
forming a gate insulating film on the base layer and the source layer;
forming a gate electrode on the gate insulating film;
forming a source electrode connected to the base layer and the source layer;
forming a first metal layer subject to an alloy processed with the semiconductor substrate on a back side of the semiconductor substrate;
forming a second metal layer on the first metal layer;
forming a third metal layer on the second metal layer; and
forming a fourth metal layer on the third metal layer.

15. The fabrication method for the semiconductor device according to claim 14, wherein the first metal layer is formed of a first Au layer, the second metal layer is formed of a Ti layer or a Cr layer, the third metal layer is formed of a Ni layer, and the fourth metal layer is formed of a second Au layer.

16. The fabrication method for the semiconductor device according to claim 14, wherein the first metal layer is formed of a first Au layer, the second metal layer is formed of a Ti layer or a Cr layer, the third metal layer is formed of a Ni layer, and the 4th metal layer is formed of a Ag layer.

17. The fabrication method for the semiconductor device according to claim 14 further comprising forming a fifth metal layer on the fourth metal layer.

18. The fabrication method for the semiconductor device according to claim 14, wherein the first metal layer is formed of a first Au layer, the second metal layer is formed of a Ti layer or a Cr layer, the third metal layer is formed of a Ni layer, the fourth metal layer is formed of a second Au layer, and the fifth metal layer is formed of a Ag layer.

19. The fabrication method for the semiconductor device according to claim 14, wherein the first metal layer is formed of a first Au layer, the second metal layer is formed of a Ti layer or a Cr layer, the third metal layer is formed of a Ni layer, the fourth metal layer is formed of a Ag layer, and the fifth metal layer is formed of a second Au layer.

20. An electric appliance comprising an inductance for load, the inductance is driven by the semiconductor device according to any one of claims 1 to 13.
